# EUROPEAN PATENT APPLICATION

(11) **EP 2 009 702 A1**
(43) Date of publication of application: **31.12.2008**
(21) Application number: 07739924.4
(22) Date of filing: 27.03.2007
(51) Int. Cl.: H01L 31/04

(54) **CIS BASED THIN FILM SOLAR CELL MODULE WITH PATTERN DISPLAY FUNCTION AND ITS FABRICATION PROCESS**

(30) Priority: 17.04.2006 JP 2006112880
(71) Applicant: Showa Shell Sekiyu Kabushiki Kaisha, Minato-ku Tokyo 135-8074 (JP)
(72) Inventor: OKAZAWA, Tadashi, c/o Showa Shell Sekiyu K.K., Tokyo 135-8074 (JP)
(74) Representative: HOFFMANN EITLE
(86) International application number: PCT/JP2007/056486
(87) International publication number: WO 2007/119535

(57) **Abstract**

A design pattern or the like is displayed on a module at low cost through simple production steps without reducing the reliability and conversion efficiency of the module to thereby improve an aesthetic sense and obtain an advertising effect. A resin film F bearing a cutout display pattern, e.g., a design, is sandwiched between a CIS based thin-film solar cell submodule 2 and a crosslinked EVA resin film 3 functioning as an adhesive. Thus, the display pattern P possessed by the film F is displayed on the surface of the thin-film solar cell module 1 while maintaining the strength of bonding between the film F and each of the submodule 2 and the cover glass 4 with the EVA resin film 3. The region F1 where the film F is absent is recognized as having the intrinsic black color of the module, and the region where the film F is present is recognized as having a gray color different from the intrinsic color of the module.

## Description

### TECHNICAL FIELD

The present invention relates to a CIS based thin-film solar cell module which has pattern-displaying function and displays a pattern such as, e.g., a character, picture, or design.

### BACKGROUND ART

With respect to Si type solar cells, it has been proposed to obtain a pattern-bearing thin-film solar cell (see, for example, patent document 1). This pattern-bearing Si type thin-film solar cell is a thin-film solar cell which has a multilayer structure composed of a light-transmitting insulating substrate, transparent conductive film, photo-electric converting layer, and back electrode layer superposed in this order from the light-receiving side and in which at least one of the insulating substrate and the transparent conductive film has a difference in haze between the region desired to be displayed and the other region so that a display pattern can be seen (recognized). The difference in haze is obtained by a method in which the substrate or conductive film is chemically etched or a method in which the substrate or conductive film is mechanically polished. In the former method, a mask for pattern formation is formed on the insulating substrate or transparent conductive film and this substrate or film is etched to thereby cause it to have a difference in haze between the masked part and the unmasked part. In the latter method, the insulating substrate or transparent conductive film is subjected to sandblasting through a metallic or another mask for pattern formation disposed thereon to thereby cause the substrate or film to have a difference in haze between the masked part and the unmasked part. However, the pattern-bearing Si type thin-film solar cell necessitates many complicated steps for the pattern-forming processing. This solar cell hence has problems that the steps result in an increase in cost and this solar cell has a reduced energy conversion efficiency.

The present applicant previously made a patent application for a CIS based thin-film solar cell module which is easy to recycle. Specifically, a CIS based thin-film solar cell module which includes a glass substrate, CIS based thin-film solar cell devices formed thereon, a cover glass, and a thermally crosslinked resin, such as an ethylene/vinyl acetate (EVA), sandwiched as an adhesive between the solar cell devices and the cover glass to bond the cover glass to the CIS based thin-film solar cell devices is modified into a structure in which the constituent members can be easily recycled, i.e., can be easily separated. The structure employed includes a non-adhesive sheet sandwiched between the CIS based thin-film solar cell devices and the resin as an adhesive, e.g., an ethylene/vinyl acetate (EVA). The present inventor visually compared this CIS based thin-film solar cell module including a non-adhesive sheet sandwiched therein with the conventional CIS based thin-film solar cell module including no non-adhesive sheet and, as a result, found that the two modules differ significantly in color and lightness. The inventor thus developed a method of providing a CIS based thin-film solar cell module having pattern-displaying function which is capable of displaying a pattern such as, e.g., a character, picture, or design based on that visual difference.

Patent Document 1: JP-A-2001-257375

### DISCLOSURE OF THE INVENTION

### PROBLEMS THAT THE INVENTION IS TO SOLVE

The invention eliminates the problems described above. An object of the invention is to enable, at low cost through simple production steps (processing method), a CIS based thin-film solar cell module to display a pattern such as, e.g., a character, picture, or design while retaining the intact solar cell characteristics including reliability and conversion efficiency to thereby improve the design characteristics of the solar cell module and obtain an advertising effect.

### MEANS FOR SOLVING THE PROBLEMS

(1) The invention provides a CIS based thin-film solar cell module having pattern-displaying function, which is a CIS based thin-film solar cell module displaying a pattern such as a character, symbol, design, or figure and comprising a structure constituted of a CIS based thin-film solar cell submodule and a cover glass comprising a semi-tempered white flat glass or the like bonded to the submodule with an ethylene/vinyl acetate (hereinafter referred to as EVA) resin film, as an adhesive, which has been crosslinked through thermal polymerization reaction,
wherein the submodule comprises CIS based thin-film solar cell devices which each comprises a glass substrate and, superposed on the substrate in the following order, an alkali barrier layer, a metallic back electrode layer, a light absorption layer, abufferlayer, and a window layer (transparent conductive film) and which have been electrically connected to each other with a conductive pattern,
wherein a pattern-bearing resin film bearing any desired display pattern, e.g., a design, formed by cutting as in the art of paper cutting is sandwiched between the window layers (transparent conductive films) of the CIS based thin-film solar cell submodule and the crosslinked EVA resin film functioning as an adhesive to thereby display the display pattern on a surface (light-receiving side) of the CIS based thin-film solar cell module.

(2) The invention provides the CIS based thin-film solar cell module having pattern-displaying function according to (1) above, wherein the display pattern comprises any one of or a combination of two or more of characters, symbols, designs, and figures.

(3) The invention provides the CIS based thin-film solar cell module having pattern-displaying function according to (1) above, wherein the pattern-bearing resin film comprises a polyester resin film.

(4) The invention provides the CIS based thin-film solar cell module having pattern-displaying function according to (1), (2), or (3) above, wherein in the surface (light-receiving side) of the CIS based thin-film solar cell module, the region where the pattern-bearing resin film is absent is visually recognized as having the intrinsic black color of the CIS based thin-film solar cell module and the region where the pattern-bearing resin film is present is visually recognized as having a gray color different from the intrinsic color of the CIS based thin-film solar cell module.

(5) The invention provides the CIS based thin-film solar cell module having pattern-displaying function according to any one of (1) to (4) above, wherein the proportion of the total area of the region where the pattern-bearing resin film is present to the light-receiving area of the CIS based thin-film solar cell module is 50% or lower.

(6) The invention provides a process for producing a CIS based thin-film solar cell module having pattern-displaying function, wherein the module is a CIS based thin-film solar cell module displaying a pattern such as a character, symbol, design, or figure and comprising a structure constituted of a CIS based thin-film solar cell submodule and a cover glass comprising a semi-tempered white flat glass or the like bonded to the submodule with an ethylene/vinyl acetate (hereinafter referred to as EVA) resin film (or sheet), as an adhesive, which has been crosslinked through thermal polymerization reaction,
wherein the submodule comprises CIS based thin-film solar cell devices which each comprises a glass substrate and, superposed on the substrate in the following order, an alkali barrier layer, a metallic back electrode layer, a light absorption layer, a buffer layer, and a window layer (transparent conductive film) and which have been electrically connected to each other with a conductive pattern,
wherein the process comprises sandwiching a pattern-bearing resin film bearing a display pattern, e.g., a design, formed by cutting as in the art of paper cutting between the window layers (transparent conductive films) and an EVA resin film, subsequently disposing a cover glass on the EVA resin film, and subjecting the resultant structure including the resin film held between the CIS based thin-film solar cell submodule and the EVA resin film and cover glass to heating under vacuum to crosslink the EVA resin film and bond the CIS based thin-film solar cell submodule to the cover glass together with the pattern-bearing resin film sandwiched therebetween.

(7) The invention provides the process for producing a CIS based thin-film solar cell module having pattern-displaying function according to (6) above, wherein the process comprises putting the structure including the pattern-bearing resin film held between the CIS based thin-film solar cell submodule and the EVA resin film and cover glass into a vacuum heating apparatus, heating the structure to 80-120°C with evacuation to cause the EVA resin film to melt and spread over the whole glass, subsequently gradually returning the internal pressure to atmospheric pressure, and heating the structure at a temperature of 120°C-160°C to crosslink the EVA resin film.

(8) The invention provides the process for producing a CIS based thin-film solar cell module having pattern-displaying function according to (6) or (7) above, wherein the pattern-bearing resin film comprises a polyester resin film.

### ADVANTAGES OF THE INVENTION

According to the invention, a CIS based thin-film solar cell module is constituted, at low cost through simple production steps (processing method), so as to display a pattern such as, e.g., a character, picture, or design while retaining the intact solar cell characteristics including reliability and conversion efficiency. Thus, the design characteristics of the solar cell module can be improved and an advertising effect can be obtained.

### BRIEF DESCRIPTION OF THE DRAWINGS

[Fig. 1] Fig. 1 (a) is a diagrammatic view (sectional view) illustrating the constitution of a CIS based thin-film solar cell module 1 having pattern-displaying function of the invention. Fig. 1 (b) is a view showing the display state (plan view) on the surface (light-receiving side) of the CIS based thin-film solar cell module 1 having pattern-displaying function of the invention.
[Fig. 2] Fig. 2 is diagrammatic views illustrating a process for producing a CIS based thin-film solar cell module 1 having pattern-displaying function of the invention.
[Fig. 3] Fig. 3 is a diagrammatic view (sectional view) illustrating the constitution of a conventional CIS based thin-film solar cell module 1A having no pattern-displaying function (the module has a frame, back sheet, etc. attached thereto).
[Fig. 4] Fig. 4 is a view (sectional view) illustrating the basic constitution of a CIS based thin-film solar cell device 2' in a CIS based thin-film solar cell module 1 having pattern-displaying function of the invention.
[Fig. 5] Fig. 5 is a diagrammatic view (sectional view) illustrating the constitution of a CIS based thin-film solar cell module 1B (having a frame, back sheet, etc. attached thereto) which has a structure including a non-adhesive sheet (e.g., polyester film) S, as a pattern-bearing resin film, sandwiched between layers.

### DESCRIPTION OF THE REFERENCE NUMERALS AND SIGNS

1 CIS based thin-film solar cell module having pattern-displaying function
1A CIS based thin-film solar cell module (no non-adhesive sheet)
1B CIS based thin-film solar cell module (having non-adhesive sheet inserted)
2 CIS based thin-film solar cell submodule
2' CIS based thin-film solar cell device
2A glass substrate
2B alkali barrier layer
2C metallic back electrode layer
2D p-type light absorption layer
2E high-resistance buffer layer
2F n-type window layer (transparent conductive film)
3 EVA resin film
F pattern-bearing resin film
F1 region where pattern-bearing resin film is absent
S non-adhesive sheet
4 cover glass
5 back sheet
6 connection box with cable
7 sealing material
8 frame

### BEST MODE FOR CARRYING OUT THE INVENTION

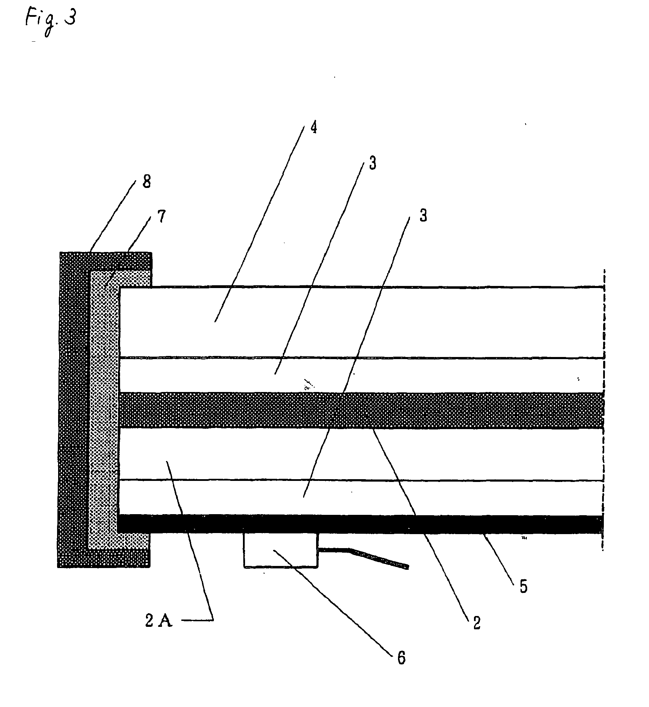

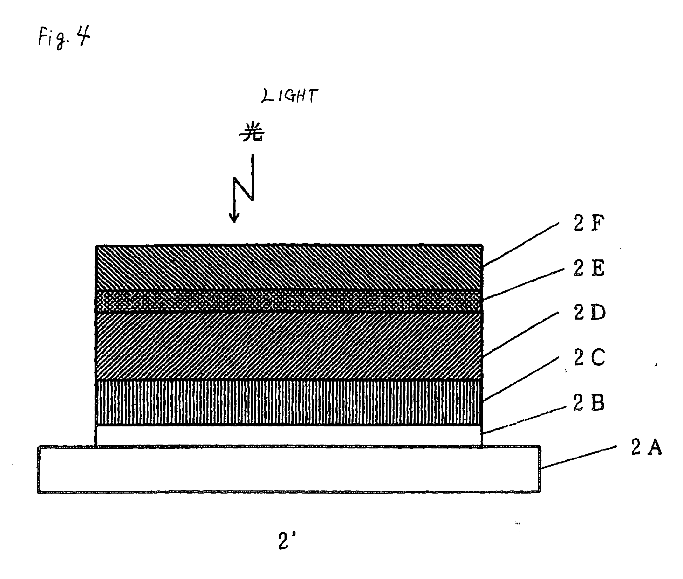

Embodiments of the invention are explained below.
The invention relates to a CIS based thin-film solar cell module which has pattern-displaying function and displays a pattern such as, e.g., a character, picture, or design. As shown in Fig. 3, a CIS based thin-film solar cell module 1A has a structure composed of: a CIS based thin-film solar cell submodule (also referred to as circuit) 2 obtained by electrically connecting CIS based thin-film solar cell devices 2' (see Fig. 4) by patterning; a cover glass 4 bonded to the submodule 2 through a thermally crosslinked EVA resin film 3 as an adhesive; a back sheet 5 bonded to the back side of the submodule, i.e., to the glass substrate 2A, through a thermally crosslinked EVA resin film 3; and a cable-possessing connection box 6 or the like disposed beneath the back sheet 5. A frame 8 is attached to the periphery of this structure through a sealing material 7.

The CIS based thin-film solar cell devices 2' each has the basic structure shown in Fig. 4. This device is a pn heterojunction device of a substrate structure which is constituted of a glass substrate 2A, e.g., a blue flat glass, and high-quality thin layers composed of an alkali barrier layer 2B, metallic back electrode layer (generally molybdenum) 2C, p-type CIS light absorption layer 2D, high-resistance buffer layer 2E, and n-type window layer (transparent conductive film) 2F which have been superposed in this order on the substrate 2A. The light absorption layer 2C is constituted of a multinary compound semiconductor thin film and is made of a p-type semiconductor such as, in particular, a I-III-VI₂ Group chalcopyrite semiconductor, e.g., copper indium diselenide (CuInSe₂: hereinafter referred to as CISe), copper indium gallium diselenide (CuInGaSe₂: hereinafter referred to as CIGSe), copper gallium diselenide (CuGaSe₂: hereinafter referred to as CGSe), copper indium gallium diselenide-sulfide (Cu(InGa)(SSe)₂: hereinafter referred to as CIGSSe), copper indium disulfide (CuInS₂: hereinafter referred to as CIS), copper gallium disulfide (CuGaS₂: hereinafter referred to as CGS), copper indium gallium disulfide (CuInGaS₂: hereinafter referred to as CIGS), or copper indium gallium diselenide (CuInGaSe₂: CIGSe) having a thin film of copper indium gallium diselenide-sulfide (Cu (InGa) (SSe)₂: CIGSSe) as a surface layer.

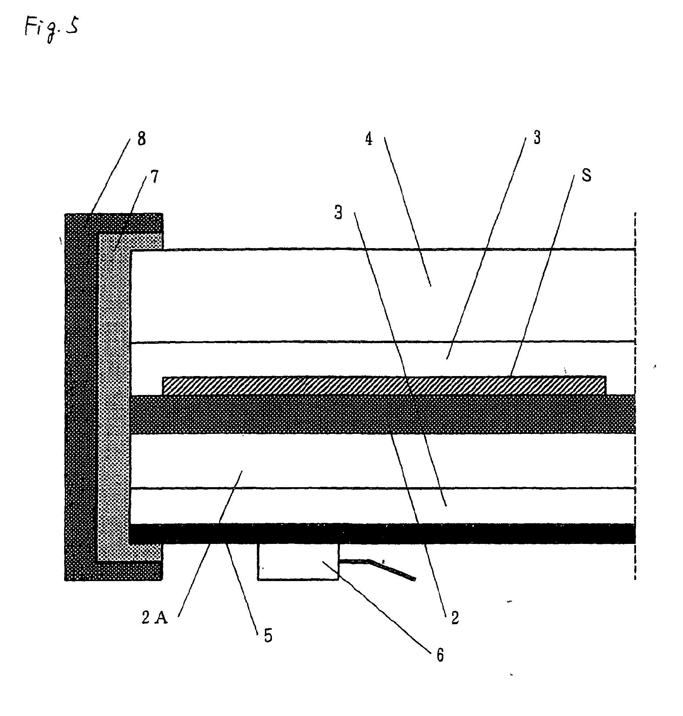

In order to make the CIS based thin-film solar cell module 1A easily recyclable, a structure was employed which, as shown in Fig. 5, included a non-adhesive sheet (e.g., polyester film) S sandwiched between the EVA resin film 3, which was for bonding the CIS based thin-film solar cell submodule 2 to the cover glass 4, and the CIS based thin-film solar cell submodule 2. This structure facilitates the separation and recovery of constituent members of the CIS based thin-film solar cell module 1B.

It was found that when a CIS based thin-film solar cell module 1A of the structure including no non-adhesive sheet (e.g., polyester film) S, i.e., not having suitability for recycling, such as that shown in Fig. 3 and a CIS based thin-film solar cell module 1B of the structure including a non-adhesive sheet (e.g., polyester film) S sandwiched between layers, i.e., having suitability for recycling, such as that shown in Fig. 5 are viewed from the light-receiving side, then the two modules differ in color, lightness, etc. The invention enables a pattern such as, e.g., a character, picture, or design to be displayed based on the difference in visual sense between the CIS based thin-film solar cell module 1A of the structure including no non-adhesive sheet (e.g., polyester film) S and the CIS based thin-film solar cell module 1B of the structure including a non-adhesive sheet (e.g., polyester film) S sandwiched between layers.

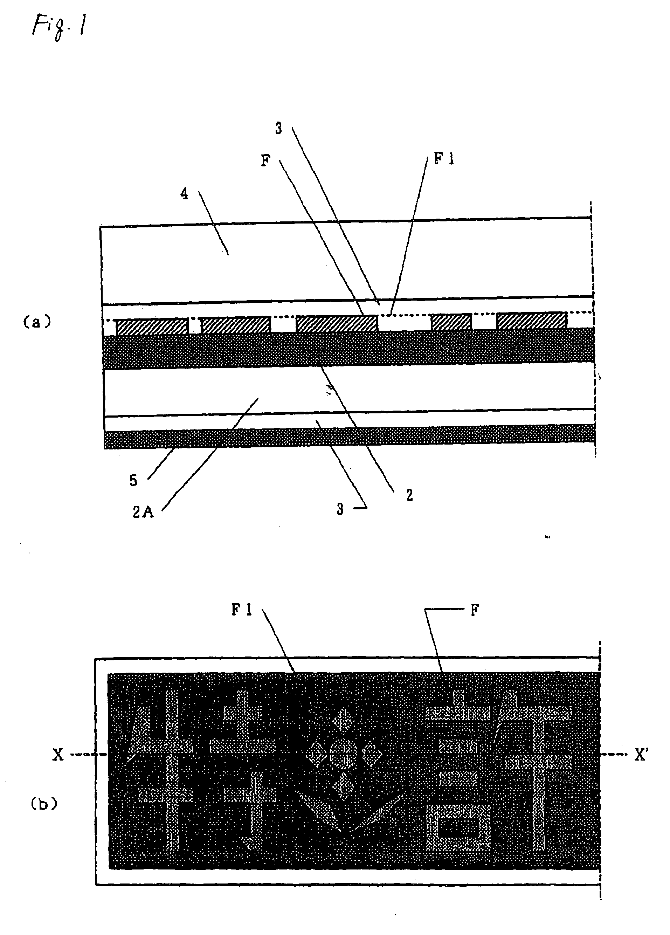

The CIS based thin-film solar cell module having pattern-displaying function of the invention and a process for producing the module are explained below.
First, the CIS based thin-film solar cell module 1 having pattern-displaying function of the invention is a CIS based thin-film solar cell module which displays a pattern such as a character, symbol, design, or figure and has a structure including a CIS based thin-film solar cell submodule 2 and a cover glass, e.g., a semi-tempered white flat glass, bonded to the submodule 2 with an ethylene/vinyl acetate (hereinafter referred to as EVA) resin film 3, as an adhesive, which has been crosslinked through thermal polymerization reaction as shown in Fig. 1 (a) (sectional view: section along the cut line X-X' in Fig. 1 (b)). A resin film F bearing a display pattern, e.g., a design, formed by cutting as in the art of paper cutting is sandwiched between the window layer (transparent conductive film) side of the CIS based thin-film solar cell submodule 2 and the crosslinked EVA resin film 3 functioning as an adhesive. Thus, the display pattern is displayed on the surface of the CIS based thin-film solar cell module 1 as shown in Fig. 1 (b) while maintaining the strength of bonding between the EVA resin film 3 and the CIS based thin-film solar cell submodule 2. This CIS based thin-film solar cell submodule 2 is constituted of CIS based thin-film solar cell devices 2' which each are composed of a glass substrate 2A and, superposed thereon in the following order, an alkali barrier layer 2B, metallic back electrode layer 2C, light absorption layer 2D, buffer layer 2E, and window layer (transparent conductive film) 2F as shown in Fig. 4 and which have been electrically connected to each other with a conductive pattern.

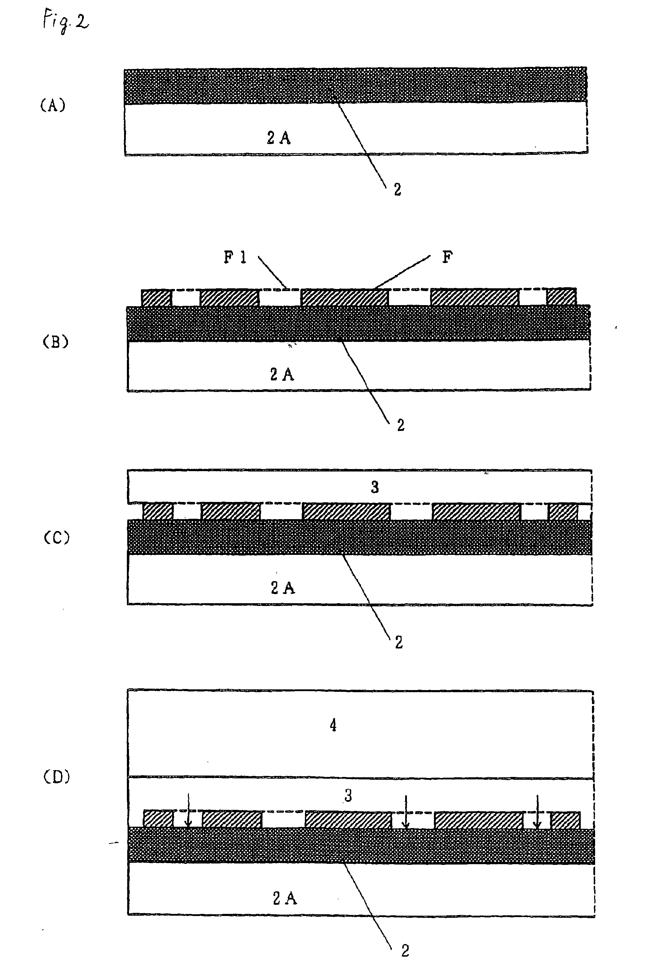

The pattern-bearing resin film F may be a film which is not a polyester resin film. However, a polyester resin film is optimal. The display pattern is constituted of any one of or a combination of two or more of characters, symbols, and designs such as those shown in Figs. 2 and 3.

In the surface (light-receiving side) of the CIS based thin-film solar cell module, the region F1 where the pattern-bearing resin film F is absent is visually recognized as having the intrinsic color (black color) of the CIS based thin-film solar cell module and the region F where the pattern-bearing resin film F is present is visually recognized as having a color (gray color) different from the intrinsic color of the CIS based thin-film solar cell module, as shown in Fig. 1 (b).

**[Table 1]**

| Change in conversion efficiency with insertion of pattern-bearing resin film F | | | | |
|---|---|---|---|---|
| Percentage film occupation (%) | Conversion efficiency of submodule only (before laminating) (%) | Conversion efficiency of module (after laminating) (%) | Change in conversion efficiency | |
| 0 (no film) | 12.4 | 11.5 | 1 | average of eleven |
| 10 | 12.7 | 11.6 | 0.988 | |
| 20 | 12.4 | 11.5 | 0.977 | |
| 50 | 12.9 | 11.8 | 0.988 | |

As shown in Table 1, it was found that the conversion efficiency of the CIS based thin-film solar cell module 1 having a pattern-bearing resin film F inserted therein differs little from that of the conventional module in which the film F has not been inserted. It was also found that the conversion efficiency changes little with the proportion of the total area of the region where the pattern-bearing resin film F is present to the light-receiving area of the CIS based thin-film solar cell module 1 (hereinafter, this proportion is referred to as percentage film occupation). Incidentally, the "Conversion efficiency of module after laminating" in Table 1 means the conversion efficiency of the CIS based thin-film solar cell module 1 obtained by superposing a pattern-bearing resin film F, EVA resin film 3, and cover glass 4 in this order on a CIS based thin-film solar cell submodule 2.

However, it is desirable that the proportion of the total area of the region where the pattern-bearing resin film F is present to the light-receiving area of the CIS based thin-film solar cell module 1 (percentage film occupation) should be 50% or lower. The reason for this is as follows. Even when the percentage film occupation is 50% or higher, solar cell characteristics including conversion efficiency decrease little. However, in the region where the pattern-bearing resin film F is present, the CIS based thin-film solar cell submodule 2 is not bonded to the EVA resin film 3. There is hence a possibility that such a high percentage film occupation might result in a decrease in mechanical strength (bonding strength).

It is desirable that the pattern-bearing resin film F should not be disposed on a peripheral part of the CIS based thin-film solar cell module 1 (or the EVA resin film 3) and that the region where the pattern-bearing resin film F is present should be distributed almost evenly.

A process for producing the CIS based thin-film solar cell module 1 having pattern-displaying function of the invention is explained next.
This is a process for producing the CIS based thin-film solar cell module 1 having pattern-displaying function shown in Fig. 1, which is a CIS based thin-film solar cell module 1 displaying a pattern such as a character, symbol, design, or figure and having a structure constituted of a CIS based thin-film solar cell submodule 2 and a cover glass 4, e.g., a semi-tempered white flat glass, bonded to the window layer (transparent conductive film) side of the submodule 2 with an ethylene/vinyl acetate (hereinafter referred to as EVA) resin film 3, as an adhesive, which has been crosslinked through thermal polymerization reaction. As shown in Fig. 2, a resin film F bearing a display pattern, e.g., a design, formed by cutting as in the art of paper cutting is sandwiched between the CIS based thin-film solar cell submodule 2 and an EVA resin film 3 (see Fig. 2 (B) and (C)). Thereafter, a cover glass 4 is disposed on the EVA resin film 3 (see Fig. 2 (D)), and the resultant structure including the pattern-bearing resin film F held between the CIS based thin-film solar cell submodule 2 and the EVA resin film 3 and cover glass 4 is heated under vacuum to crosslink the EVA resin film 3 and bond the CIS based thin-film solar cell submodule 2 to the cover glass 4, by means of the bonding force of the EVA resin film 3, together with the pattern-bearing resin film F sandwiched therebetween.

The CIS based thin-film solar cell submodule 2 is constituted of CIS based thin-film solar cell devices 2' which each are composed of a glass substrate 2A and, superposed thereon in the following order, an alkali barrier layer 2B, metallic back electrode layer 2C, light absorption layer 2D, buffer layer 2E, and window layer (transparent conductive film) 2F as shown in Fig. 4 and which have been electrically connected to each other with a conductive pattern.

The production process is explained below in detail.
The structure including the pattern-bearing resin film F held between the CIS based thin-film solar cell submodule 2 and the EVA resin film 3 and cover glass 4 (see Fig. 2 (D)) is put into a vacuum heating apparatus. The structure is heated to 80-120°C with evacuation to cause the EVA resin film 3 to melt and spread over the whole glass. Subsequently, the internal pressure is gradually returned to atmospheric pressure, and the structure is heated at a temperature of 120°C-160°C to crosslink the EVA resin film 3.

The pattern-bearing resin film F may be a film which is not a polyester resin film. However, a polyester resin film is optimal.

## Claims

1. A CIS based thin-film solar cell module having pattern-displaying function, which is a CIS based thin-film solar cell module displaying a pattern such as a character, symbol, design, or figure and comprising a structure constituted of a CIS based thin-film solar cell submodule and a cover glass comprising a semi-tempered white flat glass or the like bonded to the submodule with an ethylene vinyl acetate (hereinafter referred to as EVA) resin film, as an adhesive, which has been crosslinked through thermal polymerization reaction,
wherein the submodule comprises CIS based thin-film solar cell devices which each comprises a glass substrate and, superposed on the substrate in the following order, an alkali barrier layer, a metallic back electrode layer, a light absorption layer, a buffer layer, and a window layer (transparent conductive film) and which have been electrically connected to each other with a conductive pattern,
wherein a pattern- bearing resin film bearing any desired display pattern, e.g., a design, formed by cutting as in the art of paper cutting is sandwiched between the window layers (transparent conductive films) of the CIS based thin-film solar cell submodule and the crosslinked EVA resin film functioning as an adhesive to thereby display the display pattern on a surface (light- receiving side) of the CIS based thin-film solar cell module.

2. The CIS based thin-film solar cell module having pattern-displaying function according to claim 1, wherein the display pattern comprises any one of or a combination of two or more of characters, symbols, designs, and figures.

3. The CIS based thin-film solar cell module having pattern-displaying function according to claim 1, wherein the pattern-bearing resin film comprises a polyester resin film.

4. The CIS based thin-film solar cell module having pattern-displaying function according to claim 1, 2, or 3, wherein in the surface (light-receiving side) of the CIS based thin-film solar cell module, the region where the pattern-bearing resin film is absent is visually recognized as having the intrinsic black color of the CIS based thin-film solar cell module and the region where the pattern-bearing resin film is present is visually recognized as having a gray color different from the intrinsic color of the CIS based thin-film solar cell module.

5. The CIS based thin-film solar cell module having pattern-displaying function according to any one of claims 1 to 4, wherein the proportion of the total area of the region where the pattern-bearing resin film is present to the light-receiving area of the CIS based thin-film solar cell module is 50% or lower.

6. A process for producing a CIS based thin-film solar cell module having pattern-displaying function, wherein the module is a CIS based thin-film solar cell module displaying a pattern such as a character, symbol, design, or figure and comprising a structure constituted of a CIS based thin-film solar cell submodule and a cover glass comprising a semi-tempered white flat glass or the like bonded to the submodule with an ethylene/vinyl acetate (hereinafter referred to as EVA) resin film (or sheet), as an adhesive, which has been crosslinked through thermal polymerization reaction,
wherein the submodule comprises CIS based thin-film solar cell devices which each comprises a glass substrate and; superposed on the substrate in the following order, an alkali barrier layer, a metallic back electrode layer, a light absorption layer, abuffer layer, and a window layer (transparent conductive film) and which have been electrically connected to each other with a conductive pattern,
**characterized by** sandwiching a pattern-bearing resin film bearing a display pattern, e.g., adesign, formed by cutting as in the art of paper cutting between the window layers (transparent conductive films) and an EVA resin film, subsequently disposing a cover glass on the EVA resin film, and subjecting the resultant structure including the resin film held between the CIS based thin-film solar cell submodule and the EVA resin film and cover glass to heating under vacuum to crosslink the EVA resin film and bond the CIS based thin-film solar cell submodule to the cover glass together with the pattern-bearing resin film sandwiched therebetween.

7. The process for producing a CIS based thin-film solar cell module having pattern-displaying function according to claim 6, **characterized by** putting the structure including the pattern-bearing resin film held between the CIS based thin-film solar cell submodule and the EVA resin film and cover glass into a vacuum heating apparatus, heating the structure to 80-120°C with evacuation to cause the EVA resin film to melt and spread over the whole glass, subsequently gradually returning the internal pressure to atmospheric pressure, and heating the structure at a temperature of 120°C-160°C to crosslink the EVA resin film.

8. The process for producing a CIS based thin-film solar cell module having pattern-displaying function according to claim 6 or 7, wherein the pattern-bearing resin film comprises a polyester resin film.
